# EUROPEAN PATENT APPLICATION

(11) **EP 4 250 344 A1**
(43) Date of publication of application: **27.09.2023**
(21) Application number: 23163220.9
(22) Date of filing: 21.03.2023
(51) Int. Cl.: H01L 21/683, C04B 41/80, C04B 41/91, C04B 41/00

(54) **LASER-ROUGHENED REACTION-BONDED SILICON CARBIDE FOR WAFER CONTACT SURFACE FABRICATION**

(30) Priority: 25.03.2022 US 202217656481
(71) Applicant: II-VI Delaware, Inc., Wilmington, Delaware 19801 (US)
(72) Inventor: Coombs, Nicholas, Wilmington, 19801 (US); Coppola, Jon, Wilmington, 19801 (US); Aghajanian, Mike, Wilmington, 19801 (US); Chriss, Aaron, Wilmington, 19801 (US)
(74) Representative: Tegethoff, Sebastian

(57) **Abstract**

A method of making a ceramic device with a controlled roughness includes using a defocused laser beam to roughen a surface of a ceramic substrate, and removing one or more portions of the roughened surface without removing all of the roughened surface. If desired, the ceramic device may include reaction-bonded silicon carbide, and an opening may be formed in the device so that the device can be used to apply a clamping suction to a wafer surface. A ceramic surface with a controlled roughness is also disclosed. The defocused laser beam may be used to make the surface rough enough to prevent it from sticking to a mating element, and to have adequate wear resistance, but not so rough as to prevent the formation of sufficient suction to clamp the surface to a mating element.

## Description

### Field of the Disclosure

The present disclosure relates to a method of making a ceramic device with a controlled roughness. The present disclosure also relates to a ceramic device including a surface having a controlled roughness produced by a defocused laser beam, and a second surface having a second roughness.

### Background of the Disclosure

High A robotic device can be used to handle wafers within a processing system where human handling would be inefficient or otherwise undesirable, such as in a system for performing wafer loading and removal, chemical mechanical planarization (CMP), etching, deposition, passivation, and other processes. The robotic device may have an end effector for, among other things, loading wafers from a stack into one or more processing ports. The end effector can hold a wafer by suction applied through one or more vacuum draw eyelets. The end effector can have a forked shape, a spatula shape, or another suitable configuration. The wafer contact eyelets may be located at one or more end portions of the end effector. In operation, the vacuum draw eyelets seize and hold individual wafers for transfer and handling. The wafers can be made of silicon, semiconductor materials, or other materials.

Examples of end effectors are mentioned in United States Patent Publications Nos. 2022/0051928 (published February 17, 2022) (Transfer Device, Transfer System, and End Effector), 2020/0206954 (published July 2, 2020) (Apparatus, System and Method for Providing a Conformable Cup for an End Effector), and 2018/0215049 (published August 2, 2018) (Suction Apparatus for an End Effector, End Effector for Holding Substrates and Method of Producing an End Effector).

### Summary of the Disclosure

The present disclosure relates to a method of making a ceramic device with a controlled roughness. The method includes using a defocused laser beam to roughen a surface of a ceramic substrate, and removing one or more portions of the roughened surface without removing another portion of the roughened surface. If desired, the ceramic device may include reaction-bonded silicon carbide. If desired, an opening may be formed so that the ceramic device can be used to apply a clamping suction to a wafer surface.

The present disclosure also relates to a ceramic device including a surface having a controlled roughness produced by a defocused laser beam, and a second surface having a second roughness. The first surface may be used to form an interface with a mating element, such as a wafer. The first surface may have one or more properties for achieving a desired interface with the mating element, such as suitable roughness and adequate wear resistance. If desired, the ceramic device may include reaction-bonded silicon carbide, and may include an opening for establishing a clamping suction to the mating element, which may be, for example, the back side of a semiconductor wafer.

### Brief description of the drawings

The invention will be described based on figures. It will be understood that the embodiments and aspects of the invention described in the figures are only examples and do not limit the protective scope of the claims in any way. The invention is defined by the claims and their equivalents. It will be understood that features of one aspect or embodiment of the invention can be combined with a feature of a different aspect or aspects of other embodiments of the invention, in which:
FIG. 1 is a schematic cross-sectional view of an example of a preform material for production of a reaction-bonded silicon-carbide ceramic substrate in accordance with the present disclosure;
FIG. 2 is a schematic cross-sectional view of a reaction-bonded silicon-carbide material made from the preform material of FIG. 1, into which a vacuum draw eyelet may be machined;
FIG. 3 is a top view (not drawn to scale) of an end effector constructed in accordance with the present disclosure;
FIG. 4 is a cross-sectional view of the end effector illustrated in FIG. 3, taken along line 4-4 of FIG. 3;
FIG. 5 is a top view of a ceramic substrate for a vacuum draw eyelet of the end effector illustrated in FIGS. 3 and 4;
FIG. 6 is a top view of the substrate illustrated in FIG. 5, after the entire top surface of the ceramic substrate has been roughened by a defocused laser;
FIG. 7 is a graph of surface roughness of reaction-bonded silicon carbide as a function of number of defocused laser passes; and
FIG. 8 is a flow chart of a method of making a vacuum draw eyelet of the end effector illustrated in FIG. 3.

Throughout the drawings, like elements are designated by like reference numerals and other characters. The drawings show non-limiting examples for purposes of illustration and explanation of the present disclosure, and are not drawn to scale

### Detailed Description

The technical problem is solved by the independent claims. The dependent claims cover further specific embodiments of the invention.

Reaction-bonded silicon carbide (RB-SiC, or Si/SiC) (an example of a ceramic material) may be used in a variety of products and systems, including semiconductor equipment, industrial wear, thermal management, furnace components, armor, etc. Attractive properties of reaction-bonded silicon carbide include low thermal-expansion, high thermal-conductivity, high hardness, high wear-resistance, high stiffness, and chemical inertness.

Reaction-bonded silicon carbide is a multi-phase material formed by reactive infiltration in which molten elemental silicon (Si) is brought into contact with a porous mass of interconnected silicon-carbide (SiC) particles plus carbon (C) in a vacuum or inert atmosphere. A wetting condition is created such that the molten silicon is pulled by capillary action into the mass of interconnected silicon-carbide particles and carbon, and the silicon reacts with the carbon in the mass to form additional silicon carbide. The resulting reaction-bonded silicon-carbide material contains primarily silicon carbide, but also unreacted, interconnected silicon.

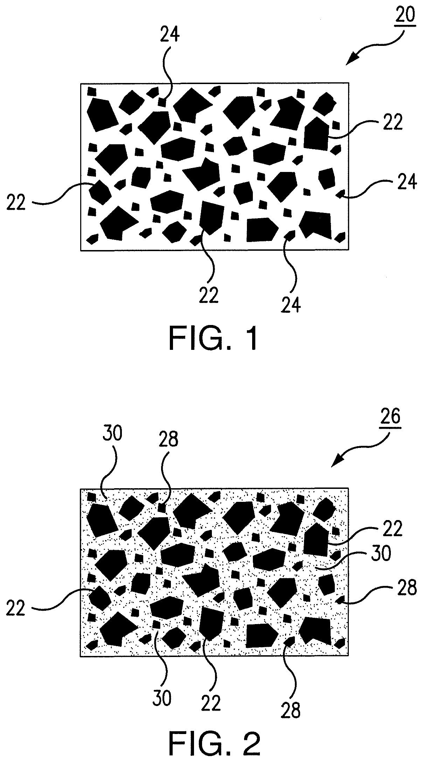

The infiltration process is illustrated in FIGS. 1 and 2. FIG. 1 is a schematic cross-sectional view of a porous mass (or preform) 20 which contains interconnected silicon-carbide particles 22 and carbon 24. FIG. 2 is a schematic cross-sectional view of a reaction-bonded silicon-carbide material (a ceramic material) 26 after infiltration by molten silicon, and subsequent cooling. The infiltration may occur in a vacuum or inert atmosphere.

In the illustrated process, the molten silicon reactively infiltrates into the preform 20 (FIG. 1) such that the reaction-bonded silicon-carbide material 26 (FIG. 2) has a microstructure made up of three elements: (1) the original silicon-carbide particles 22; (2) reaction-formed silicon carbide (Si + C => SiC) 28, and (3) residual (unreacted) elemental silicon 30. The silicon 30 expands as it solidifies from its liquid state, such that the reacted, solidified three-component microstructure 22, 28, 30 is fully dense.

Thus, as the term is used herein, reaction-bonded silicon carbide is a fully dense, two-phase composite of silicon-carbide particles in a continuous silicon matrix. Reaction-bonded silicon carbide is mentioned in United States Patent Application No. 17/248,309 (filed January 19, 2021) and United States Patent Publications Nos. 2021/0331985 (published October 28, 2021), 2018/0099379 (published April 12, 2018), and 2017/0291279 (published October 12, 2017). The entire disclosures of United States Patent Application No. 17/248,309 and United States Patent Publications Nos. 2021/0331985, 2018/0099379, and 2017/0291279 are incorporated herein, in their entireties, by reference.

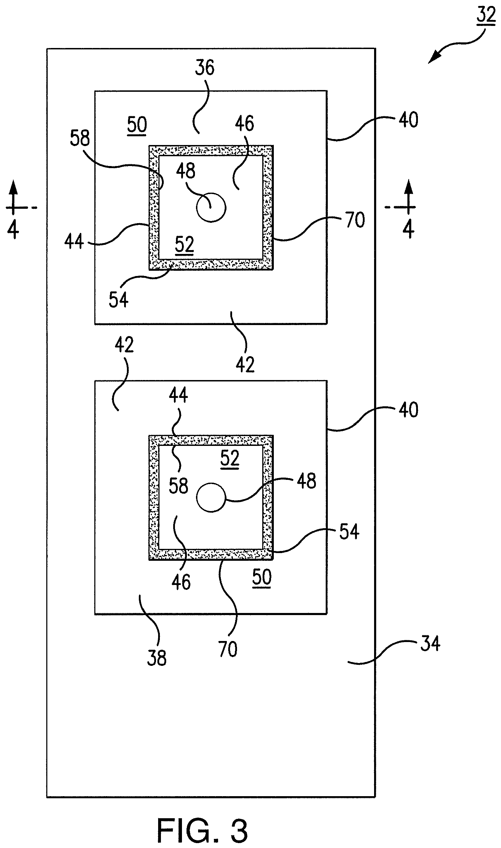

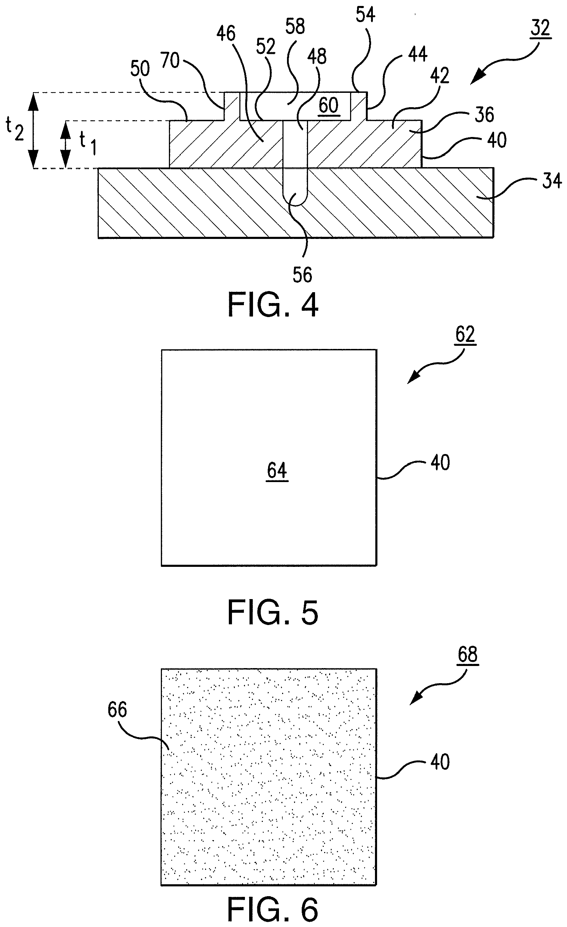

Referring now to FIG. 3, an end effector 32 has at least one arm 34 and one or more vacuum draw eyelets (or vacuum pads) 36, 38. Each vacuum draw eyelet 36, 38 has a periphery 40, a main section 42 of a reduced thickness t1 (FIG. 4), at least one wafer-contact portion 44 of a greater thickness t2, an inner section 46 of the reduced thickness t1, and a vacuum port 48. The main section 42 is located inwardly of the periphery 40. The at least one wafer-contact portion 44 is located inwardly of the main section 42. The inner section 46 is located inwardly of the at least one wafer-contact portion 44. The reduced thickness t1 is less than the greater thickness t2. The vacuum port 48 is located inwardly of the inner section 46.

If desired, the top surfaces 50, 52 of the main and inner sections 42, 46 may be formed by a suitable machining process, as described in more detail below. In the illustrated configuration, the top surface 54 of the wafer-contact portion 44 is roughened by a defocused laser, and is not subsequently machined, as described in more detail below. In FIG. 3, the top surface 54 of the wafer-contact portion 44 is illustrated with stippling to schematically represent its laser-roughened surface texture. According to one aspect of the present disclosure, reaction-bonded silicon carbide is ideal for laser roughening because the two microstructural phases of the composite material are removed at different rates.

Each vacuum draw eyelet 36, 38, including in each case the main, wafer-contact, and inner sections 42, 44, 46, may be formed in one integral piece of a reaction-bonded silicon-carbide material. As illustrated in FIG. 4, the length of the vacuum port 48 is the same as the reduced thickness t1 of the inner section 46, and the vacuum port 48 is connected to a source of vacuum 56 located within the end-effector arm 34.

Each one of the vacuum draw eyelets 36, 38 may have essentially the same structure and configuration, may be produced (manufactured) in essentially the same way, may be connected to the same vacuum source 56, and may operate in essentially the same way. The vacuum draw eyelets 36, 38 (examples of wafer-contact devices) are connected to the end-effector arm 34 by suitable adhering agents or connecting devices (not illustrated in the drawings). The present disclosure is not limited, however, to the specific configurations and processes illustrated in the drawings and described herein except to the extent such features are mentioned in the accompanying claims.

In operation, the entire top surface 54 of the wafer-contact portion 44 may come into contact with the back side of a semiconductor wafer (not illustrated). When such contact occurs, a plane which contains essentially all of the top surface 54 of the wafer-contact portion 44 is coincident with a plane which contains the back side of the wafer, at least in the vicinity of the wafer-contact portion 44. The top surface 52 of the inner section 46, the back side of the wafer, and inwardly-facing surfaces 58 of the wafer-contact portion 44 form a suction chamber 60 (FIG. 4). Air (or another gas) is removed from the suction chamber 60, though the vacuum port 48, by the vacuum source 56, to establish suction within the chamber 60 to securely adhere (or clamp) the wafer to the end effector 32.

As described in more detail below, the desired defocused laser roughening causes the top surface 54 of the wafer-contact portion 44 to be sufficiently rough to prevent the top surface 54 from sticking to the back side of the wafer. The top surface 54 may not be so rough, however, as to permit air (or another gas) to leak into the suction chamber 60, through the contact interface between the top surface 54 and the back side of the wafer, and prevent the wafer from adhering to the end effector 32.

In operation, a suitable robotic system connected to the end effector 32 moves the end-effector arm 34 such that the eyelets 36, 38 come into contact with the bottom surface of a wafer (not illustrated). A vacuum is then drawn through the end effector 32 and applied through the vacuum eyelets (or pads) 36, 38 to securely attach the wafer to the end effector 32. The robotic system then moves the wafer to another desired location. Subsequently, the application of vacuum from the vacuum source 56 may be discontinued such that the wafer is released from the vacuum pads 36, 38 and the end effector 32 can be moved away from the wafer.

Referring now to FIGS. 5 and 6, a ceramic substrate 62 for a respective one of the vacuum pads 36, 38 may be provided with a common top surface 64 formed by grinding, slicing, or another suitable technique. The average surface roughness (Ra) of the common top surface 64 may be about 0.2 micron (µm), which may be too flat or smooth to prevent sticking to the clamped surface of the wafer. The entire top surface 64 may be roughened by a defocused laser to produce the roughened top surface 66 shown in FIG. 6. The roughened surface 66 is rougher than the surface 64 shown in FIG. 5. Laser roughening using a defocused laser causes the surface 64 to be roughened, but it does not cut the surface 64.

The defocused laser may pass across the surface 64 a desired number of times to achieve a desired, customer-requested, surface roughness. If desired, the thickness of the roughened ceramic substrate 68 may be the same as the greater thickness t2 of the wafer-contact portion 44 (FIG. 3). The roughness of the roughened top surface 66, represented schematically by stippling in FIG. 6, may be the same as the roughness of the top surface 54 (FIG. 3) of the wafer-contact portion 44 in the finished product 36 (38).

After the ceramic substrate 62 illustrated in FIG. 5 is subjected to defocused laser roughening, the roughened surface 66 is subjected to a suitable machining process, which may be an electrical discharge machining (EDM), focused laser machining, or another machining process. The machining (relief) process removes material from the roughened ceramic substrate 68 to produce the top surfaces 50, 52 of the reduced-thickness main and inner sections 42, 46, and establishes the inner sides 58 and outer sides 70 of the wafer-contact portion 44, without affecting the top surface 54 or any other part of the wafer-contact portion 44. The machining process leaves the wafer-contact portion 44 standing proud above the top surfaces 50, 52 of the main and inner sections 42, 46, and leaves the top surface 54 of the wafer-contact portion 44 with the desired surface roughness created by the defocused laser roughening process.

If desired, instead of or in addition to the eyelets 36, 38, an end effector may have rings for establishing a vacuum chamber for clamping the back side of a wafer to an arm of the end effector. The rings may have a suitable roughness established by defocused laser roughening on surfaces where the rings come into contact with the wafer, to obtain the desired clamping without sticking.

Thus, according to the present disclosure, a reaction-bonded silicon-carbide material has a surface that has a suitable roughness created by defocused laser roughening to prevent back side wafer contamination and permit the roughened device to have a long useful life (with low wear). The wafer contact surface 54 should be sufficiently rough to prevent it from sticking to the wafer. If the wafer contact surface 54 were too flat and smooth, it would tend to undesirably stick to the back side of the wafer by a phenomenon referred to as "optical contacting" or "contact bonding." The phenomenon is mentioned in A Study of Glass Surfaces in Optical Contact, Lord Rayleigh, Proc. Phys. Soc., A156, 326 (1936), and Optical Contacting Grows More Robust, Chris Myatt, Nick Traggis, and Kathy Li Dessau, Laser Focus World, January 1, 2006. A "sticky" interface with the wafer may not be acceptable, especially in connection with a semiconductor fabrication system which requires the end effector 32 to efficiently and rapidly clamp and un-clamp (release) wafers.

On the other hand, the roughness of the wafer-contact surface 54 should not be so rough as to permit a vacuum leak through its interface with the back side of the wafer, or to permit undesirable, premature wear. If the contact surface is too rough, adequate vacuum clamping may not be achievable. That is, air (or another gas) could leak between the wafer and the reaction-bonded silicon-carbide material between the peaks and valleys of the too-rough surface. Moreover, a too-rough (spikey) surface could wear quickly due to a low bearing ratio.

The present disclosure advantageously employs reaction-bonded silicon-carbide material for wafer contact surfaces of vacuum end effectors (vacuum EEs) that can be used to robotically move wafers through a semiconductor manufacturing facility. Compared to other possible wafer contact materials, such as polymer, metal, and oxide ceramic, reaction-bonded silicon carbide provides high purity, high hardness, and a consistent tribological interface. For applications where reaction-bonded silicon carbide touches a wafer surface, a well-controlled surface roughness may be required. If the wafer-contact surface is too smooth, the wafer may stick via optical contact bonding, and if the surface is too rough, a vacuum leak may occur and prevent robust clamping.

Thus, the present disclosure describes a laser roughening method for generating a desired controlled roughness of a wafer contact component formed of reaction-bonded silicon carbide and located on an end effector assembly. As indicated above, reaction-bonded silicon carbide may be particularly well suited to roughening because it is a two-phase composite material of silicon carbide (SiC) and elemental silicon (Si), and the two phases are machined at different rates.

The roughening process may be performed by a laser beam applied to the surface 64 of the substrate 62. If desired, the laser beam may be generated by a DMG Mori LaserTech 45 shape machine tool which is a fiber-laser tool configured for producing a 100 watt (W) laser beam, with a beam wavelength (λ) of 1,064 nanometers (nm). The laser beam should be defocused, that is, the ideal focus of the beam should be displaced from the surface 64 of the ceramic substrate 62. The substrate surface 64 should be roughened but not cut. According to one aspect of the present disclosure, the roughened surface should have an average roughness (Ra) in the range of from 0.3 to 1.1 µm. According to another aspect of the present disclosure, the roughened surface may have an average roughness (Ra) in the range of from 0.36 to 0.44 µm. If desired, the average surface roughness may be measured by a Mitutoyo SJ-210 surface profilometer.

In operation, the laser beam may be defocused by displacing the ideal focus of the laser beam away from the substrate surface 64, in a direction orthogonal to the substrate surface 64, by a distance in the range of from 0.9 to 1.1 millimeters (mm). The intensity of the laser beam at the point where its defocused portion is incident on the wafer surface may be in the range of from 7.2 to 8.8 W. The laser beam may be pulsed with a pulse frequency (f) in the range of from 90 to 110 kilohertz (kHz). The pulse duration (t) of the laser beam may be in the range of from 109 to 132 nanoseconds (ns). The tracking velocity (v) of the laser beam, that is, the velocity at which an incident portion of the beam moves across the substrate surface 64, in the plane of the substrate surface 64, may be in the range of from 2,250 to 2,750 millimeters per second (mm/s).

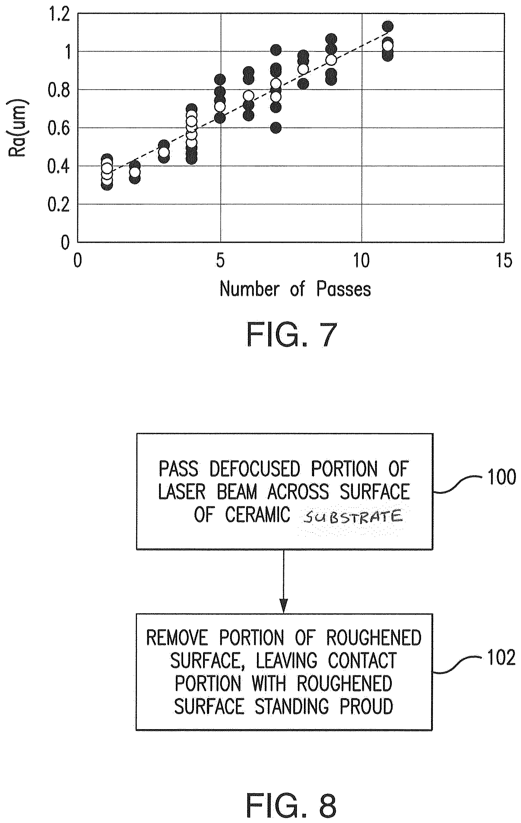

If desired, components with a roughness gradient can be made by using a different number of laser passes at different surface locations. FIG. 7 is a graph of average surface roughness Ra (µm) of a reaction-bonded silicon-carbide material as a function of the number of passes performed by the defocused laser described above.

The present disclosure is not limited to the fabrication or use of the eyelets 36, 38 described herein. The laser-roughening process may also be used to produce a variety of other devices with ceramic, especially reaction-bonded silicon carbide, surfaces, including end-effector pads, rings, and cups. The laser-roughening process described herein may also be used to produce a variety of other devices that may be used in a semiconductor fabrication plant, especially devices which contact wafers, and where controlled surface roughness is desired, such as vacuum wafer pin chucks, vacuum wafer through-hole chucks, and electrostatic chucks. The laser-roughening process described herein may also be used to produce a variety of other devices, especially ceramic devices, where it is desirable for one or more surfaces of the device to have a controlled roughness, such as bearing seals, cylinder liners, human artificial joints (hips, knees, etc.), bonding surfaces, and air-bearing surfaces.

Turning now to FIG. 8, according to one aspect of the present disclosure, a defocused-laser controlled roughening process includes the steps of providing a ceramic substrate 62, passing a defocused portion of a laser beam across the substrate surface 64 a desired number of times to create a roughened surface 66 (step 100), and then machining away (removing) one or more portions of the roughened surface 66 to leave a contact portion 44 standing proud above relieved surfaces 50, 52 (step 102). According to a preferred aspect of the present disclosure, the surface 54 of the contact portion 44 and the surrounding relieved surfaces 50, 52 may be integral (of one single piece of material) with each other and may be formed of reaction-bonded silicon-carbide material (or another suitable ceramic material). If desired, the controlled roughness of the surface 54 of the contact portion 44 may be used to establish a suction chamber 60 adjacent the back side of a semiconductor wafer.

In exchange for disclosing the inventive concepts contained herein, the Applicants desire all patent rights afforded by the appended claims. Therefore, it is intended that the appended claims include all modifications and alterations to the full extent that they come within the scope of the following claims or the equivalents thereof.

## Claims

1. A method of making a ceramic device with a controlled roughness, the method comprising:
- providing a ceramic substrate with a first surface;
- producing a roughened surface by roughening the first surface; and
- removing a first portion of the roughened surface without removing a second portion of the roughened surface.

2. The method of claim 1, wherein the roughening includes passing a defocused laser beam over the first surface.

3. The method of claim 1, wherein the roughening includes repeatedly passing a defocused laser beam over the first surface.

4. The method of claim 3, wherein the roughening includes passing the defocused laser beam a first number of times over a first portion of the first surface and passing the defocused laser beam a second number of times over a second portion of the first surface, the first number of times being greater than the second number of times, such that the roughened surface has first and second portions of different average roughnesses.

5. The method of claim 1, wherein the ceramic substrate includes a reaction-bonded silicon-carbide material.

6. The method of claim 1, wherein the ceramic device is a vacuum device for an end effector.

7. A ceramic device comprising:
- a first surface having a controlled roughness produced by a defocused laser beam, wherein the first surface is configured to provide one or more interfacial properties with a mating element; and
- a second surface having a second roughness, the controlled roughness being different from the second roughness.

8. The ceramic device of claim 7, wherein the one or more interfacial properties include high wear-resistance, vacuum sealing, low friction, and low stickiness.

9. The ceramic device of claim 8, wherein the ceramic device includes reaction-bonded silicon carbide.

10. The ceramic device of claim 7, wherein the device is an element of a vacuum end effector, and wherein the first surface is configured to prevent the device from sticking to a wafer, and to provide a vacuum seal at an interface between the first surface and the wafer.

11. The ceramic device of claim 10, further comprising an opening for connecting a suction chamber to a vacuum source.

12. A method of making an end effector, comprising:
- providing a substrate having a surface formed of reaction-bonded silicon-carbide material;
- creating a roughened surface by passing a defocused portion of a laser beam across the substrate surface;
- removing a portion of the roughened surface while leaving a contact portion of the roughened surface standing proud; and
- connecting the contact portion to an arm of the end effector.

13. The method of claim 12, wherein the substrate surface includes a ceramic surface, and wherein an average surface roughness (Ra) of the roughened surface is greater than an average surface roughness (Ra) of the ceramic surface.

14. The method of claim 13, wherein the average surface roughness of the roughened surface is in a range of from 0.3 to 1.1 µm.

15. The method of claim 14, wherein the average surface roughness of the roughened surface is in a range of from 0.36 to 0.44 µm.

16. The method of claim 12, wherein the substrate surface includes a ceramic surface, and wherein the defocused portion of the laser beam is incident on the ceramic surface while the laser beam is passed multiple times across the ceramic surface.
